**Europäisches Patentamt**

**European Patent Office**

**Office européen des brevets**

(19)

(11) **EP 1 427 104 A1**

(12) **EUROPEAN PATENT APPLICATION**
published in accordance with Art. 158(3) EPC

(43) Date of publication:
09.06.2004 Bulletin 2004/24

(51) Int Cl.⁷: **H03H 17/06**, H03H 17/02

(21) Application number: 02772838.5

(86) International application number:
**PCT/JP2002/009047**

(22) Date of filing: 05.09.2002

(87) International publication number:
**WO 2003/023961 (20.03.2003 Gazette 2003/12)**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **10.09.2001 JP 2001273350**

(71) Applicants:
• **Koyanagi, Yukio**
**Saitama-shi, Saitama 336-0932 (JP)**

• **Neuro Solution Corp.**
**Tokyo 158-0091 (JP)**

(72) Inventor: **KOYANAGI, Yukio**
**Saitama-shi, Saitama 336-0932 (JP)**

(74) Representative: **VOSSIUS & PARTNER**
**Postfach 86 07 67**
**81634 München (DE)**

(54) **SOUND QUALITY ADJUSTING DEVICE AND FILTER DEVICE USED THEREFOR&comma; SOUND QUALITY ADJUSTING METHOD&comma; AND FILTER DESIGNING METHOD**

(57)    A filter circuit is composed of FIR filters, and the filter factor is of a symmetrical type, thereby realizing a linear phase characteristic and preventing phase distortion even if a desired frequency band is emphasized. The first filter factors of a low-pass filter are determined so that the first filter factors may be the terms of a sequence in which the sum of the terms is not zero, the sign of the sum of every other terms is the same as that of the other every other terms, and the sum of the every other terms is equal to that of the other every other terms. Thus, by only changing a part of the signs of the filter factors, second filter factors of a high-pass filter can be simply determined so that they may be the terms of a sequence in which the sum of the terms is zero, the sign of the sum of every other terms is opposite to that of the other every other terms, and the absolute value of the sum of the every other terms is equal to that of the other every other terms.

F I G. 1

## Description

[Background of the Invention]

[Field of the Invention]

The present invention relates to a sound quality adjusting device and a filter device used therefor, a sound quality adjusting method, and a filter designing method and is particularly suitable for a device and a method for improving sound quality by emphasizing or de-emphasizing a desired frequency band of a sound signal by digital signal processing.

[Description of the Related Art]

Conventionally various methods are proposed to improve sound quality of output sound in devices for outputting sound signals. A method of performing low-pass filtering and high-pass filtering on input sound signals is relatively simple among such methods.

In such a sound quality adjusting device, an input sound signal passes through a low-pass filter and a high-pass filter and the gains of an output signal and an input sound signal of the filters are controlled and summed. In this case, a gain of the output from the filter and a gain of the input sound signal are arbitrarily set, so that sound with a desired frequency band can be arbitrarily emphasized.

For example, when a sound in a low-frequency area (so-called bass) is emphasized, an output signal from the low-pass filter is increased in gain. Further, when a sound in a high-frequency area (so-called treble) is emphasized, an output signal from the high-pass filter is increased in gain.

In the conventional sound quality adjusting device, it is desirable that the low-pass filter and the high-pass filter both have linear phase characteristics and a gain be perfectly set at 1 (reference value) in all frequency bands when the output signals of the filters are added without controlling gains.

The linear phase characteristic is demanded for the following reason: when a phase shift is caused by the passage of a sound signal through the filters, sound quality degrades due to phase distortion and sound becomes difficult to hear in some cases (particularly at a low volume level). Moreover, the summed gains are demanded to be perfectly equal to the reference value in all the frequency bands because a state with no sound quality adjustment has to be realized when gain control is absent.

Conventionally an IIR (Infinite Impulse Response) filter and an FIR (Finite Impulse Response) filter are frequently used as a digital filter. The FIR filter has the following advantages: first, since the transfer factor of the FIR filter has a pole only on the origin of the z-plane, a circuit is always stabilized, and second, linear phase characteristics are achieved with complete accuracy.

Therefore, in response to the demands, it is desirable to use, in a sound quality adjusting device, a symmetrical FIR filter which is composed of a pair of a low-pass filter and a high-pass filter with symmetrical frequency characteristics. In general the low-pass filter is basically used for the FIR filter and the high-pass filter is derived from the low-pass filter by frequency conversion. Hence, in the symmetrical FIR filter, it is necessary to first design a basic low-pass filter and perform frequency conversion thereon so that a high-pass filter is designed with characteristics symmetrical to those of the low-pass filter.

Conventionally in frequency conversion for deriving a high-pass filter from an FIR low-pass filter, the cut-off frequency of the filter is converted. To be specific, convolution or the like using a window function, Chebyshev approximation, and so forth is performed based on a ratio of a sampling frequency and a cut-off frequency, so that the transfer factor of the filter is determined. The transfer factor is further changed into a frequency component.

However, in the frequency conversion using a window function, Chebyshev approximation, and so forth, calculation is extremely complicated. Thus, calculation performed by software increases a processing load and calculation performed by hardware increases a circuit size.

Further, the frequency characteristics of a filter that are obtained by conventional design methods depend upon a window function and an approximate expression. Thus, when the window function and an approximate expression are not properly set, excellent frequency characteristics cannot be obtained. However, it is generally difficult to properly set a window function and an approximate expression and thus it is quite demanding to design a filter with desired frequency characteristics.

Moreover, a method of directly determining the filter factors of a high-pass filter and so forth without using frequency conversion is also available. However, in this case, filter factors required for desired frequency characteristics have to be determined by trial and error, so that a design cannot be made with ease.

The present invention is devised to solve the above-described problems. An object of the present invention is to prevent phase distortion even when a desired frequency band is emphasized, obtain good quality sound on audibility by digital signal processing, and readily design a filter circuit used for such sound quality adjustment.

[Summary of the Invention]

A sound quality adjusting device of the present invention for causing an input sound signal to pass through a plurality of digital filters, controlling the gains of the output signals from the plurality of digital filters, summing the sound signals having been subjected to gain control, and outputting the sum, characterized in that the device comprises a first filter for multiplying a signal of each tap of a tapped delay line by several times according to given first filter factors and then performing addition and output, the delay line being made up of a plurality of delay units, and a second filter for multiplying a signal of each tap of a tapped delay line by several times according to given second filter factors and then performing addition and output, the delay line being made up of a plurality of delay units, the first filter factors have a symmetrical sequence in which values are set so that the sum is not zero and the sum of every other terms is equal to the sum of the other every other terms with the same signs, and the second filter factors have a symmetrical sequence in which values are set so that the sum is zero and the sum of every other terms is equal to the sum of the other every other terms with opposite signs.

Another aspect of the present invention is characterized in that in the second filter factors, the signs of values other than the median of the sequence of the first filter factors are changed while causing the absolute values of the sequence to remain the same.

Still another aspect of the present invention is characterized in that in the second filter factors, the signs of values other than the median of the sequence of the first filter factors are changed while causing the absolute values of the sequence to remain the same, and themedian of the sequence is subtracted from a reference value.

For example, the sequence of the first filter factors is composed of ratios of -1, 0, 9, 16, 9, 0, and -1 and the sequence of the second filter factors is composed of ratios of 1, 0, -9, 16, -9, 0, and 1.

Still another aspect of the present invention is characterized in that at least one of the first filter and the second filter is cascaded to the subsequent stage of at least one of the first filter and the second filter.

For example, the first filter and the second filter are cascaded in parallel to the subsequent stage of the first filter, the first filter and the second filter are cascaded in parallel to the subsequent stage of the second filter, control is performed on a gain of an output signal from each of the cascaded filters in the subsequent stage, and sound signals having been subjected to gain control are summed and outputted.

Further, a filter device of the present invention, characterized in that the device comprises a first filter for multiplying a signal of each tap of a tapped delay line by several times according to given first filter factors and then performing addition and output, the delay line being made up of a plurality of delay units, and a second filter for multiplying a signal of each tap of a tapped delay line by several times according to given second filter factors and then performing addition and output, the delay line being made up of a plurality of delay units, the first filter factors have a symmetrical sequence in which values are set so that the sum is not zero and the sum of every other terms is equal to the sum of the other every other terms with the same signs, and the second filter factors have a symmetrical sequence in which values are set so that the sum is zero and the sum of every other terms is equal to the sum of the other every other terms with opposite signs.

Moreover, a sound quality adjusting method of the present invention, characterized by comprising: a first filtering step of multiplying a signal of each tap of a tapped delay line, which delays an input sound signal, by several times by using first filter factors and then performing addition and output, the first filter factors having a symmetrical sequence in which values are set so that the sum is not zero and the sum of every other terms is equal to the sum of the other every other terms with the same signs, a second filtering step of multiplying a signal of each tap of a tapped delay line, which delays the input sound signal, by several times by using second filter factors and then performing addition and output, the second filter factors having a symmetrical sequence in which values are set so that the sum is zero and the sum of every other terms is equal to the sum of the other every other terms with opposite signs, a gain controlling step of controlling a gain of the sound signal having passed through the first filtering step and a gain of the sound signal having passed through the second filtering step, and a summing step of summing the sound signals having undergone gain control in the gain controlling step and outputting the sum.

Further, a filter designing method according to the present invention for designing a plurality of digital filters in which frequency characteristics are complementary to each other and the total gain of the filters serves as a reference value at all frequencies, characterized in that based on first filter factors having a symmetrical sequence in which values are set so that the sum is not zero and the sum of every other terms is equal to the sum of the other every other terms with the same signs, the sequence of the first filter factors is changed, so that second filter factors having a symmetrical sequence are determined in which values are set so that the sum is zero and the sum of every other terms is equal to the sum of the other every other terms with opposite signs, and the first filter factors and the second filter factors are used as the filter factors of the plurality of digital filters.

[Brief Description of the Drawings]

FIG. 1 is a block diagram showing a schematic structural example of a sound quality adjusting device according to the present embodiment;
FIG. 2 is a diagram showing a basic structural example of an FIR filter;
FIG. 3 is an explanatory drawing showing filter factors used in the present embodiment;

FIG. 4 is a diagram showing frequency-gain characteristics of the filter factors shown in FIG. 3;

FIG. 5 is a diagram showing the frequency-gain characteristics of a sequence indicated by [4] of FIG. 3 and a sequence in which some signs are changed;

FIGS. 6A to 6C are block diagrams showing the configuration of a three-tap FIR filter;

FIGS. 7A and 7B are diagrams showing the frequency characteristics of the three-tap FIR filter;

FIGS. 8A to 8C are block diagrams of the configuration of a five-tap FIR filter;

FIG. 9 is a diagram showing the frequency characteristics of the five-tap FIR filter;

FIG. 10 is a block diagram showing the configuration of a seven-tap FIR filter;

FIG. 11 is a diagram showing the frequency characteristics of the seven-tap FIR filter;

FIGS. 12A and 12B are block diagrams showing the configuration of the seven-tap FIR filter;

FIGS. 13A and 13B are diagrams showing the frequency characteristics of the seven-tap FIR filter;

FIG. 14 is a block diagram showing another structural example of the sound quality adjusting device according to the present embodiment;

FIGS. 15A to 15D are diagrams showing the frequency characteristics of the cascade connection of the filters;

FIG. 16 is a diagram showing the frequency-gain characteristics of a four-channel filter bank;

FIG. 17 is a block diagram showing a specific structural example of the sound quality adjusting device shown in FIG. 14;

FIG. 18 is a diagram showing a matrix composed of data at the center frequency of each channel;

FIG. 19 is a diagram showing matrixs used for determining a gain control signal;

FIG. 20 is a frequency-gain characteristic diagram showing the results of frequency control performed by the sound quality adjusting device using the four-channel filter bank; and

FIGS. 21A and 21B are diagrams for explaining the meaning of a digital basic function used in the present embodiment.

[Detailed Description of the Preferred Embodiments]

An embodiment of the present invention will be described below in accordance with the accompanying drawings.

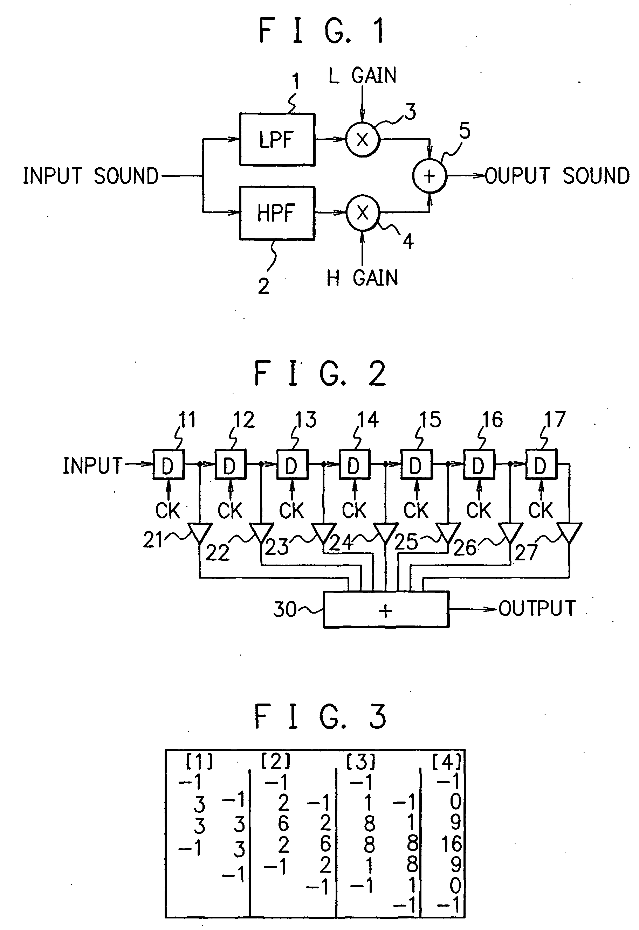

FIG. 1 is a block diagram showing the schematic configuration of a sound quality adjusting device according to the present embodiment. In the sound quality adjusting device of FIG. 1, an input sound signal is caused to pass through a low-pass filter (LPF) 1 and a high-pass filter (HPF) 2, the gains of output signals from the filters are controlled by multipliers 3 and 4, and the results are summed and outputted by an adder 5.

In such a configuration, it is desirable that the filters 1 and 2 have linear phase characteristics and a resultant gain, which is obtained by summing output signals from the filters 1 and 2 without gain control (L gain = H gain = 1), be perfectly set at 1 (reference value) in all frequency bands. Hence, the present embodiment uses an FIR filter as a filter circuit constituting the sound quality adjusting device. This is because a symmetrical sequence of a plurality of factors provided in the filter circuit can achieve linear phase characteristics and stabilize the circuit all the time.

FIG. 2 is a diagram showing a basic structural example of the FIR filter. FIG. 2 shows the configuration of a seven-tap FIR filter. In the FIR filter, seven cascaded D-type flip-flops 11 to 17 sequentially delay an input sound signal by one clock CK. Then, signals extracted from the output taps of the D-type flip-flops 11 to 17 are multiplied by filter factors by seven factor units 21 to 27, and the multiplication results are all added and outputted by an adder 30.

In the present embodiment, a sequence {-1, 0, 9, 16, 9, 0, -1} indicated by [4] of FIG. 3 is used as symmetrical filter factors provided for the FIR filter. The filter factors indicated by [4] have a symmetrical sequence in which the sum is not zero and the sum of every other terms is equal to the sum of the other every other terms with the same signs (-1 + 9 + 9 + (-1) = 16, 0 + 16 + 0 = 16).

The filter factors indicated by [4] of FIG. 3 are obtained by performing a moving-average calculation once on a digital basic function indicated by [3] of FIG. 3. The digital basic function changes a data value to -1, 1, 8, 8, 1, -1 for each clock. The sequence of the digital basic function is obtained by performing the moving-average calculation twice on a sequence indicated by [1] of FIG. 3.

Besides, the integer sequence indicated by [4] of FIG. 3 is used as filter factors in the present embodiment. In this case, the sum of all the filter factor values is 32, which serves as a reference value. In reality the values of the sequence are multiplied by 1/32 and are used as filter factors in order to standardize a gain at 1. In this case, the reference value is 1.

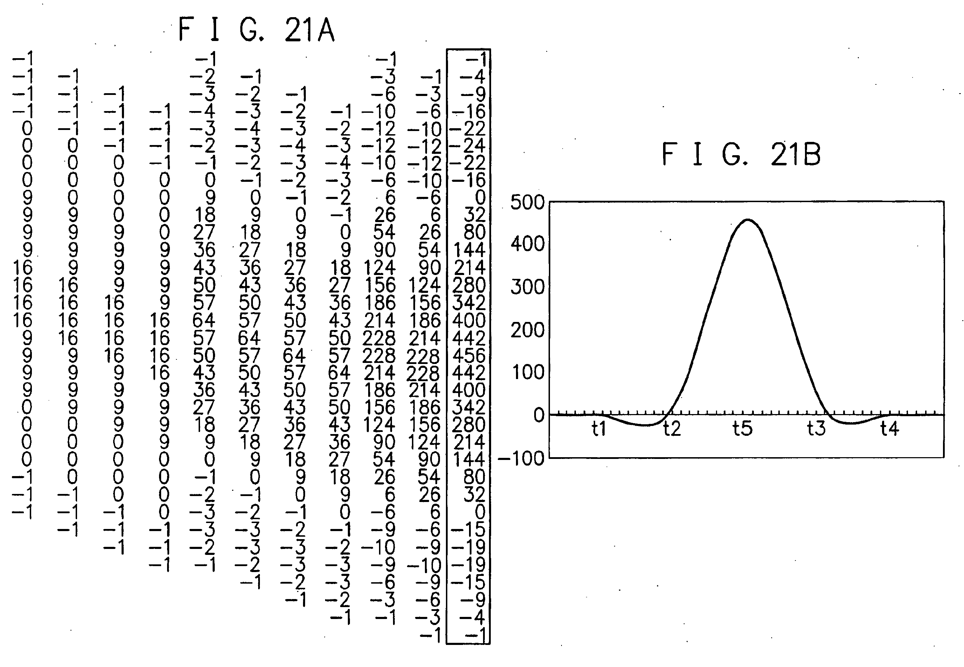

Referring to FIGS. 21A and 21B, the meaning of the sequence of the digital basic function will be discussed below.

FIGS. 21A and 21B are diagrams showing the results of quadruple oversampling and convolution on the sequence {-1, 0, 9, 16, 9, 0, -1} which is obtained by performing the moving-average calculation once on the digital basic function.

In FIG. 21A, a series of numeric values on the leftmost column is obtained by performing quadruple oversampling on the original sequence {-1, 0, 9, 16, 9, 0, -1}. Further, numeric values in four columns from the left to the right are obtained by shifting down the numeric values of the leftmost sequence one by one. The column direction of FIG. 21A indicates a time base. Shifting down numeric values is to gradually delay the numeric values of the leftmost column.

Namely numeric values in the second column from the left indicate numeric values obtained by shifting the numeric values of the leftmost column by a quarter phase of a clock 4CK with quadruple frequency. Further, numeric values in the third column from the left indicate numeric values obtained by shifting numeric values in the second column from the left by a quarter phase of the clock 4CK with quadruple frequency, and numeric values in the fourth column from the left indicate numeric values obtained by further shifting numeric values in the third column from the left by a quarter phase of the clock 4CK with quadruple frequency.

Moreover, numeric values in the fifth column from the left are obtained by adding numeric values in the corresponding rows of the first to fourth columns and dividing the results by four. With the processing on the five columns from the left, quadruple oversampling is performed in a digital fashion together with four-phase convolution.

Numeric values in four columns from the fifth column to the right are obtained by shifting down numeric values in the fifth column one by one. Further, numeric values in the ninth column from the left are obtained by adding numeric values in the corresponding rows of the fifth to eighth columns and dividing the results by four. With the processing on the nine columns from the left, quadruple oversampling is performed twice in a digital fashion together with four-phase convolution.

Besides, numeric values in the tenth column from the left are obtained by shifting down numeric values in the ninth column by one. Further, numeric values in the eleventh column (rightmost column) from the left are obtained by adding numeric values in the corresponding rows of the ninth column and the tenth column and dividing the results by two.

The final numeric values in the rightmost column of FIG. 21A are shown in graph form in FIG. 21B. A function with the waveform of FIG. 21B has a finite value other than "0" only when a sample position along the horizontal axis lies between t1 and t4. In other areas, the function always has a value "0", that is, the value of the function converges to "0" at the sample positions t1 and t4. In this way, when the function has a finite value other than "0" in a local area and has "0" in other areas, this state is referred to as "finite base."

Moreover, the function of FIG. 21B is a sampling function which has the maximum value only on a sample position t5 at the center and has "0" on four sample positions of t1, t2, t3, and t4. The function passes through all the sample points required for data of a smooth waveform.

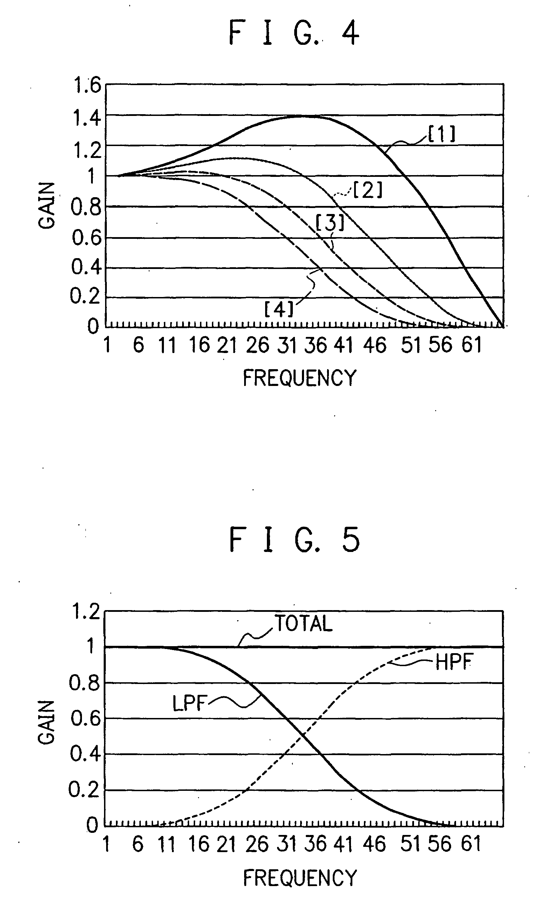

FIG. 4 shows frequency-gain characteristics of the results of FFT (Fast Fourier Transfer) performed on the sequences [1] to [4] of FIG. 3. Besides, a gain is standardized at "1" in FIG. 4. As is understood from the characteristic diagram, when the sequence [4] is used as filter factors, the center frequency has a gain of 0.5 and excellent low-pass filter characteristics can be obtained so that no overshoot occurs in a low frequency area and no ringing occurs in a high frequency area.

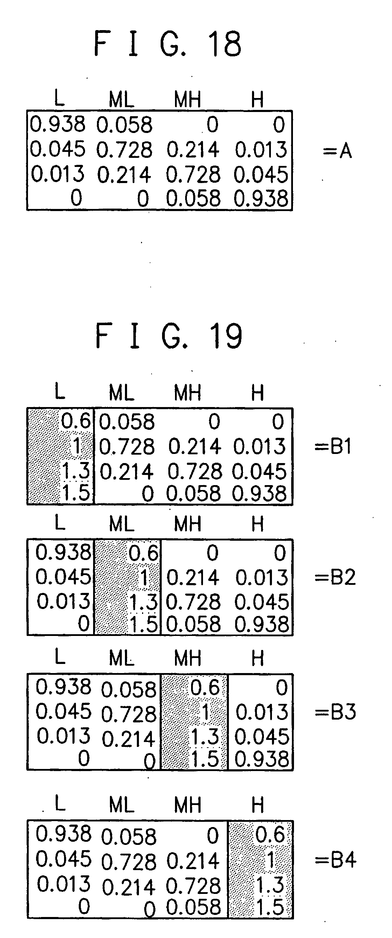

The sequence {-1, 0, 9, 16, 9, 0, -1} achieving such low-pass filter characteristics is a basic sampling function of a finite base shown in FIG. 19B. While a conventionally used sampling function converges to "0" on a sample position t = ±∞, the sampling function of FIG. 19B converges to "0" on a finite sample position t = t1, t4.

Thus, when FET is performed on the sequence, only data corresponding to the range of t = t1 to t4 is significant. It is not true that the data corresponding to a range other than t = t1 to t4 is ignored even though the data should be essentially considered. The data does not have to be considered in theory. Hence, no truncation error occurs. Therefore, by using the sequence as filter factors, it is possible to obtain excellent low-pass filter characteristics without the necessity for truncating factors by a window function. Hence, the sequence is used for the basic low-pass filter.

The high-pass filter constituting the symmetrical FIR filter with the low-pass filter is derived from the basic low-pass filter. The derived high-pass filter has frequency-gain characteristics which are symmetrical laterally and vertically with respect to the center frequency axis as compared with the basic low-pass filter. Further, when the gain outputs of the basic low-pass filter and the high-pass filter are summed, the gain is perfectly set at 1 (reference value) in all the frequency bands.

As described above, filter factors used for the basic low-pass f ilter are {-1, 0, 9, 16, 9, 0, -1}. The sum of the sequence of the filter factors is 32. The sum of every other terms of the sequence is 16 (=(-1) + 9 + 9 + (-1)) and the sum of the other every other terms of the sequence is 16 (= 0 + 16 + 0), which are equal to each other.

The sum of the sequence is not 0 but 32. This means that the output of a direct current or low-frequency component of an input sound signal is not 0. The sum of every other terms is equal to the sum of the other every other terms in the sequence. This means that the output (output of each tap) of a high-frequency component of the input sound signal remains the same. It is understood that the same characteristics as those of the low-pass filter are obtained.

On the other hand, regarding filter factors used for the high-pass filter, the signs of values other than the median of the sequence are changed while the absolute values of the sequence are caused to remain the same in order to maintain the symmetrical property with respect to the basic low-pass filter. The sum of the sequence of the filter factors is set at 0 and the sum of every other terms is made equal to the . sum of the other every other terms in the sequence with opposite signs. A sequence of filter factors satisfying such conditions is {1, 0, -9, 16, -9, 0, -1}. That is, the sum of the sequence of the filter factors is 0, the sum of every other terms is -16 (= 1 +(-9) + (-9) + 1) and the sum of the other every other terms is 16 (= 0 + 16 + 0) in the sequence.

The sum of 0 in the sequence means that the output of a direct current or low-frequency component of the input sound signal is 0. Further, the sum of every other terms is equal to the sum of the other every other terms with opposite signs in the sequence. This means that the output (output of each tap) of the high-frequency component of the input sound signal alternately changes. It is understood that the same characteristics as those of the high-pass filter are obtained.

FIG. 5 is a diagram showing frequency-gain characteristics as a result of FET on the sequence {-1, 0, 9, 16, 9, 0, 1} indicated by [4] of FIG. 3 and the sequence {1, 0, -9, 16, -9, 0, -1} in which some signs are changed. Also in FIG. 5, a gain is standardized at 1. As is understood from the characteristic diagram, the frequency characteristics intersect with each other at the gain of 0.5 on the center frequency, the characteristics are laterally and vertically symmetrical, and the total of gains is perfectly set at 1 in all the frequency bands. That is, the frequency characteristics are the same as the characteristics of the symmetrical FIR filter composed of a pair of a low-pass filter and a high-pass filter.

The above explanation will be described in detail. The following will discuss conditions for designing the symmetrical FIR filter constituting the sound quality adjusting device.

1) The FIR filter is composed of a low-pass filter and a high-pass filter that have symmetrical properties and the total of gains is perfectly set at 1 in all the frequency bands.
2) Filter factors increase from ends to the center.
3) The median of the filter factors is not 0 (median of 0 causes a notch).

(Three-tap filter)

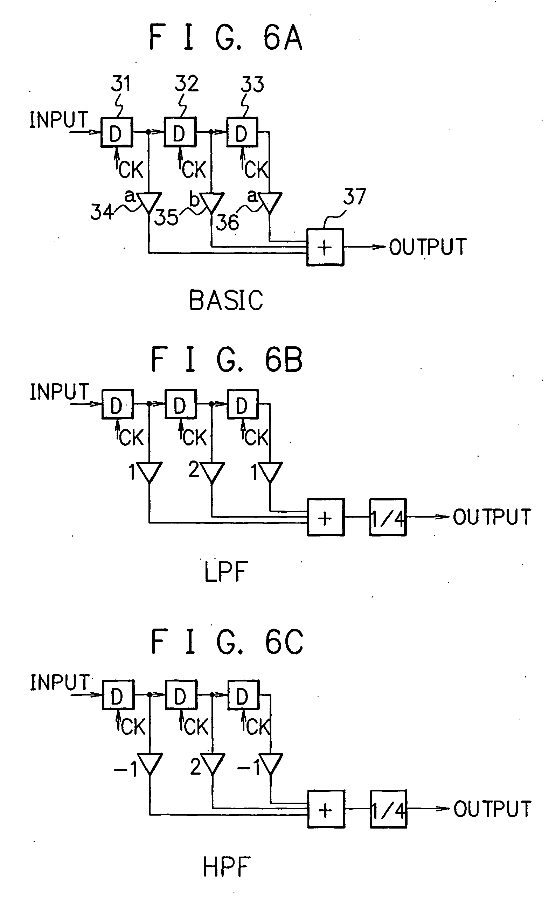

FIG. 6A is a block diagram showing the basic configuration of a three-tap FIR filter. In FIG. 6A, reference numerals 31 to 33 denote three cascaded D-type flip-flops which sequentially delay an input sound signal by one clock CK.

Reference numerals 34 to 36 denote three factor units which multiply signals extracted from the output taps of the D-type flip-flops 31 to 33 by several times by using given symmetrical filter factors (a, b, a). Reference numeral 37 denotes an adder which adds the output signals of the factor units 34 to 36 and outputs the result. The filter factors provided for the FIR filter configured thus are properly determined, so that the FIR filter can be designed as a low-pass filter or a high-pass filter.

When the reference value is assumed to be 1, the three-tap FIR filter serves as a low-pass filter on the following absolute requirements:

(1) The sum of the sequence of factors is 1 (low-frequency condition)
(2) A difference is 0 between the sum of every other terms and the sum of the other every other terms in the sequence of factors (highest frequency condition), and the gain of the center frequency of the low-pass filter is set at 0.5 on the following condition:
(3) A difference is 0.5 between the sum of every other two terms and the sum of the other every other two terms in the sequence of factors (intermediate frequency condition)

The conditions (1) to (3) are expressed below.

Condition (1)      2a + b = 1

Condition (2)      2a - b = 0

Condition (3)      (a + b) - a = 0.5

Based on the conditions, a = 1/4 and b = 1/2 are determined. Therefore, the circuit of the low-pass filter is configured as shown in FIG. 6B.

On the other hand, the three-tap FIR filter serves as a high-pass filter on the following absolute requirements:

(4) The sum of the sequence of factors is 0 (low-frequency condition)
(5) A difference is 1 between the sum of every other terms and the other every other terms in the sequence of factors (highest frequency condition), and the gain of the center frequency of the high-pass filter is set at 0.5 on the following condition:
(6) A difference is 0.5 between the sum of every two terms and the sum of the other every two terms in the sequence of factors (intermediate frequency condition)

The conditions (4) to (6) are expressed as below.

Condition (4)      2a + b = 0

Condition (5)      2a - b = 1

Condition (6)      (a + b) - a = 0.5

Based on the conditions, a = -1/4 and b = 1/2 are determined. Therefore, the circuit of the high-pass filter is configured as shown in FIG. 6C.

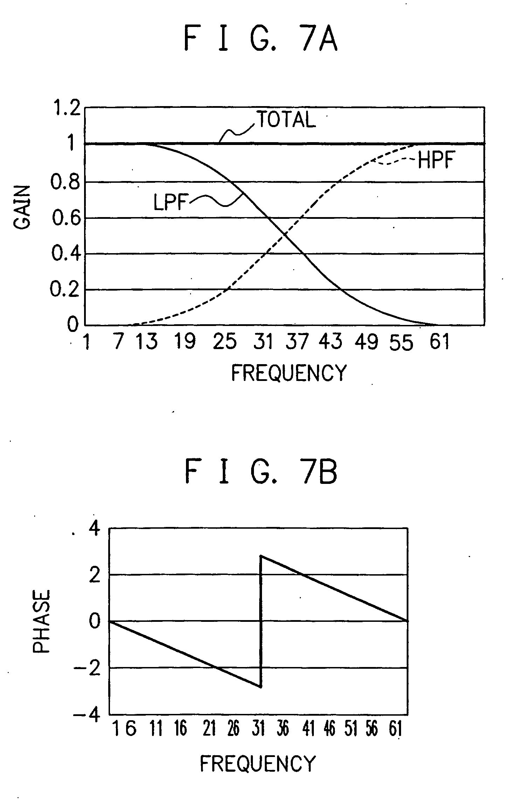

FIG. 7A shows the frequency-gain characteristics of the low-pass filter and the high-pass filter shown in FIGS. 6B and 6C. FIG. 7B is a diagram showing the frequency-phase characteristics of the low-pass filter shown in FIG. 6B. As is understood from the characteristic diagrams, the frequency characteristics of the low-pass filter and the high-pass filter intersect with each other at a gain of 0.5 on the center frequency, the characteristics are laterally and vertically symmetrical, and the total of gains is perfectly set at 1 in all the frequency bands. Further, linear phase characteristics are completely obtained.

(Five-tap filter)

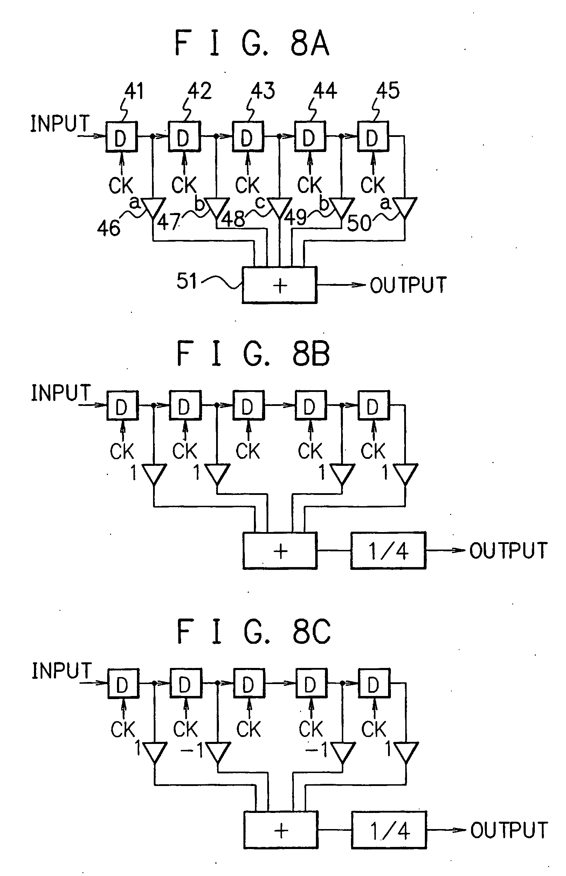

FIG. 8A is a block diagram showing the basic configuration of a five-tap FIR filter. In FIG. 8A, reference numerals 41 to 45 denote five cascaded D-type flip-flops which sequentially delay an input sound signal by one clock CK.

Reference numerals 46 to 50 denote five factor units which multiply signals extracted from the output taps of the D-type flip-flops 41 to 45 by several times by using given symmetrical filter factors (a, b, c, b, a). Reference numeral 51 denotes an adder which adds the output signals of the factor units 46 to 50 and outputs the result.

The five-tap FIR filter serves as a low-pass filter on the following absolute requirements:

(1) The sum of the sequence of factors is 1 (low-frequency condition)
(2) A difference is 0 between the sum of every other terms and the sum of the other every other terms in the sequence of factors (highest frequency condition), and the gain of the center frequency of the low-pass filter is set at 0.5 on the following condition:
(3) A difference is 0.5 between the sum of every two terms and the sum of the other every two terms in the sequence of factors (intermediate frequency condition)

The conditions (1) to (3) are expressed as below.

$$\text{Condition (1)} \qquad 2a + 2b + c = 1$$

$$\text{Condition (2)} \qquad 2a + c - 2b = 0$$

$$\text{Condition (3)} \qquad (a + b) - (c + b) + a = 0.5$$

Based on the conditions, $a = b = 1/4$ and $c = 0$ are determined. Therefore, the circuit of the low-pass filter is configured as shown in FIG. 8B. However in this case, since the sequence of filter factors has a median c at 0 and causes a notch, the configuration is not preferable.

On the other hand, the five-tap FIR filter serves as a high-pass filter on the following absolute requirements:

(4) The sum of the sequence of factors is 0 (low-frequency condition)
(5) A difference is 1 between the sum of every other terms and the other every other terms in the sequence of factors (highest frequency condition), and the gain of the center frequency of the high-pass filter is set at 0.5 on the following condition:
(6) A difference is 0.5 between the sum of every two other two terms and the sum of the other every two terms in the sequence of factors (intermediate frequency condition)

The conditions (4) to (6) are expressed as below.

$$\text{Condition (4)} \qquad 2a + 2b + c = 0$$

$$\text{Condition (5)} \qquad 2a + c - 2b = 1$$

$$\text{Condition (6)} \qquad \{a + (b + a)\} - (b + c) = 0.5$$

Based on the conditions, $a = 1/4$, $b = -1/4$, and $c = 0$ are determined. Therefore, the circuit of the high-pass filter is configured as shown in FIG. 8C. However in this case, since the sequence of filter factors has a median c of 0 and causes a notch, the configuration is not preferable.

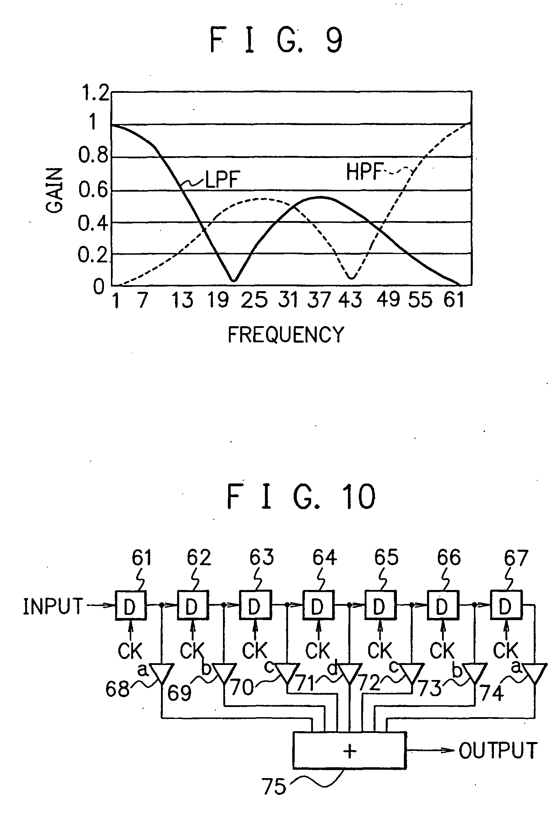

FIG. 9 is a diagram showing the frequency-gain characteristics of the low-pass filter and the high-pass filter of FIGS. 8B and 8C. As is understood from the characteristic diagram, since the sequence of filters has a median value c of 0, a notch occurs.

(Seven-tap filter)

FIG. 10 is a block diagram showing the basic configuration of a seven-tap FIR filter. In FIG. 10, reference numerals 61 to 67 denote seven cascaded D-type flip-flops which sequentially delay an input sound signal by one clock CK.

Reference numerals 68 to 74 denote seven factor units which multiply signals extracted from the output taps of the D-type flip-flops 61 to 67 by several times by using given symmetrical filter factors (a, b, c, d, c, b, a). Reference numeral 75 denotes an adder which adds the output signals of the factor units 68 to 74 and outputs the result. Filter factors provided for the FIR filter configured thus are properly determined, so that the FIR filter can be designed as a low-pass filter or a high-pass filter.

The seven-tap FIR filter serves as a low-pass filter on the following absolute requirements:

(1) The sum of the sequence of factors is 1 (low-frequency condition)

(2) A difference is 0 between the sum of every other terms and the sum of the other every other terms in the sequence of factors (highest frequency condition), and the gain of the center frequency of the low-pass filter is set at 0.5 on the following condition:

(3) A difference is 0.5 between the sum of every other two terms and the sum of the other every other two terms in the sequence of factors (intermediate frequency condition)

The conditions (1) to (3) are expressed as below.

$$\text{Condition (1)} \qquad 2a + 2b + 2c + d = 1$$

$$\text{Condition (2)} \qquad 2a + 2c - 2b - d = 0$$

$$\text{Condition (3)} \qquad \{a + (d + c)\} - \{(b + c) + (b + a)\}$$
$$= d - 2b = 0.5$$

Since $d + 2b = 1/2$ is determined based on the conditions (1) and (2), $b = 0$ and $d = 1/2$ are determined based on condition (3).

As a result, the following combinations are available as factors a and c.

$$a = -1/32, c = 9/32$$

$$a = -2/32, c = 10/32$$

$$a = -3/32, c = 11/32$$

$$a = -4/32, c = 12/32$$

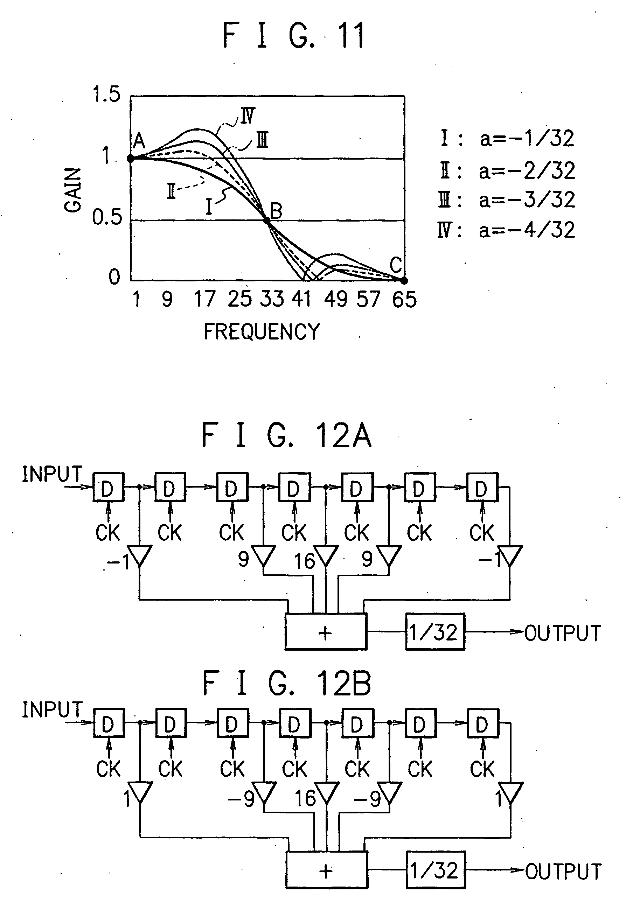

FIG. 11 is a diagram showing frequency-gain characteristics obtained when four patterns of combinations of $b = 0$ and $d = 1/2$ and a and c are provided as the sequence of filter factors. As shown in FIG. 11, in any of the four patterns of the sequence, the frequency characteristics pass through three points A, B, and C in FIG. 11 ( the center frequency has a gain of 0.5 at point B). However, the vertically symmetrical property found only when $a = -1/32$ and $c = 9/32$ are established. Therefore, this combination is used for the factors a and c. In this case, the circuit of the low-pass filter is configured as shown in FIG. 12A.

As is evident from the above description, the seven-tap low-pass filter has laterally and vertically symmetrical frequency-gain characteristics only when the sequence of filter factors is {-1, 0, 9, 16, 9, 0, -1}. Therefore, the sequence {-1, 1, 8, 8, 1, -1} of a digital basic factor and the sequence {-1, 0, 9, 16, 9, 0, -1}, which is obtained by performing a moving-average calculation once on the digital basic function, are quite useful in digital signal processing.

On the other hand, the seven-tap FIR filter serves as a high-pass filter on the following absolute requirements:

(4) The sum of the sequence of factors is 0 (low-frequency condition)

(5) A difference is 1 between the sum of every other terms and the sum of the other every other terms in the sequence of factors (highest frequency condition), and the gain of the center frequency of the high-pass filter is set at 0.5 on the following condition:

(6) A difference is 0.5 between the sum of every other two terms and the sum of the other every other two terms in the sequence of factors (intermediate frequency condition)

The conditions (4) to (6) are expressed as below:

$$\text{Condition (4)} \qquad 2a + 2b + 2c + d = 0$$

$$\text{Condition (5)} \qquad 2a + 2c - 2b - d = 1$$

$$\text{Condition (6)} \qquad \{a + (d + c)\} - \{(b + c) + (b + a)\} =$$
$$d - 2b = 0.5$$

Based on conditions (4) and (5), $d + 2b = 1/2$ is determined. Thus, $b = 0$ and $d = 1/2$ are determined based on condition (6).

According to the results, as with the low-pass filter, the combination of $a = 1/32$ and $c = -9/32$ is used for the values of the factors a and c. In this case, the circuit of the high-pass filter is configured as shown in FIG. 12B. As is understood from the above description, the seven-tap high-pass filter has laterally and vertically symmetrical frequency-gain characteristics only in the sequence of filter factors {1, 0, -9, 16, -9, 0, 1}.

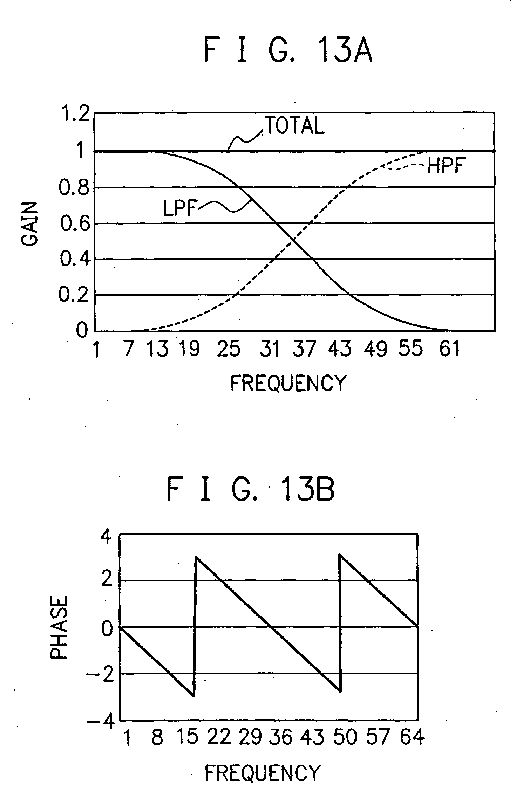

FIG. 13A shows the frequency-gain characteristics of the low-pass filter and the high-pass filter of FIGS. 12A and 12B. FIG. 13B is a diagram showing the frequency-phase characteristics of the low-pass f ilter and the high-pass f ilter of FIGS. 12A and 12B. As is understood from the characteristic diagrams, the frequency characteristics of the low-pass filter and the high-pass filter intersect with each other at a gain of 0.5 on the center frequency, the characteristics are laterally and vertically symmetrical, and the total of gains is perfectly set at 1 in all the frequency bands. Further, linear phase characteristics are completely obtained.

As described above, according to the present embodiment, the filter of the sound quality adjusting device is constituted of the FIR filter and symmetrical filter factors are provided in the filter, thereby achieving linear phase characteristics. Therefore, even when a desired frequency band is emphasized, phase distortion does not occur and good quality sound can be obtained on audibility by digital signal processing.

Further, according to the present embodiment, the sequence satisfying the predetermined conditions is provided as filter factors for the FIR low-pass filter. Thus, the high-pass filter can be designed simply by changing some signs of filter factors of the low-pass filter. Hence, it is possible to design a symmetrical FIR filter (a pair of the low-pass filter and the high-pass filter) for sound quality adjustment with great ease.

The above explanation described an example where based on the low-pass filter using the sequence with ratios of {-1, 0, 9, 16, 9, 0, -1} as filter factors, the filter factors are changed so as to determine the filter factors of the high-pass filter. Conversely, based on the high-pass filter using the sequence with ratios of {1, 0, -9, 16, -9, 0, 1} as filter factors, the filter factors may be changed so as to determine the filter factors of the low-pass filter.

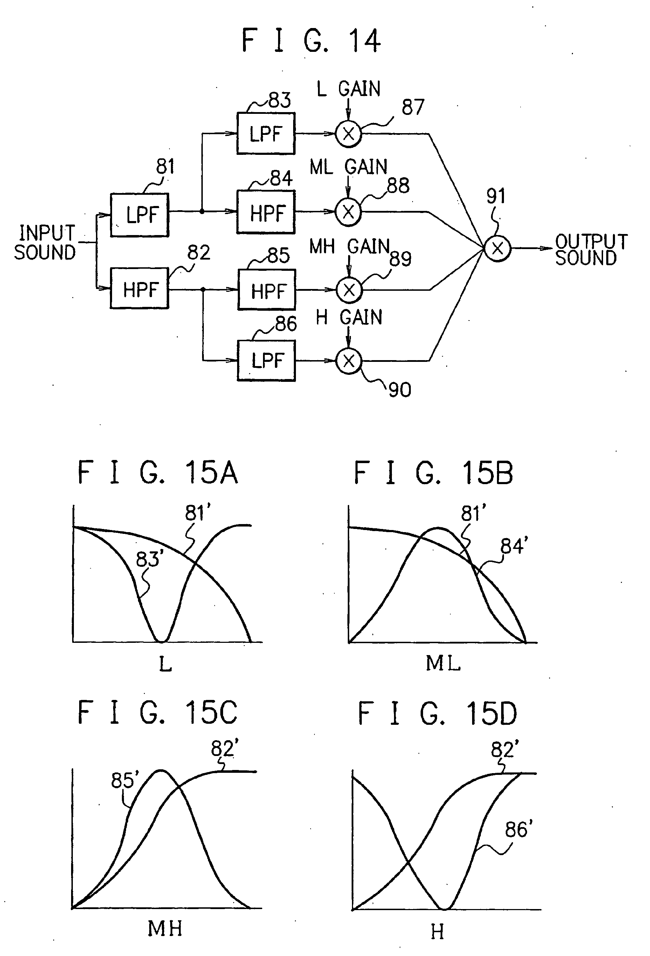

The following will describe an application example of the above-described symmetrical FIR filter. FIG. 14 is a block diagram showing another schematic structural example of the sound quality adjusting device according to the present embodiment. In the sound quality adjusting device of FIG. 14, a low-pass filter 83 and a high-pass filter 84 are cascaded in parallel in the subsequent stage of a low-pass filter 81, which is configured as the low-pass filter 1 of FIG. 1. Moreover, a high-pass filter 85 and a low-pass filter 86 are cascaded in parallel in the subsequent stage of a high-pass filter 82, which is configured as the high-pass filter 2 of FIG. 1.

In this configuration, the frequency axes of the cascaded filters 83 to 86 in the subsequent stage is half the frequency axes of the filters 81 and 82 in the previous stage. FIGS. 15A to 15D show frequency-gain characteristics in the cascade connection of the filters 81 to 86. In FIGS. 15A to 15D, the frequency characteristics of the filters 81 to 86 are indicated by reference numerals with '. FIGS. 15A to 15D show frequency characteristics on the cascade connection of the low-pass filter 81 and the low-pass filter 83 in the subsequent stage, frequency characteristics on the cascade connection of the low-pass filter 81 and the high-pass filter 84 in the subsequent stage, frequency characteristics on the cascade connection of the high-pass filter 82 and the high-pass filter 85 in the subsequent stage, and frequency characteristics on the cascade connection of the high-pass filter 82 and the low-pass filter 86 in the subsequent stage, respectively.

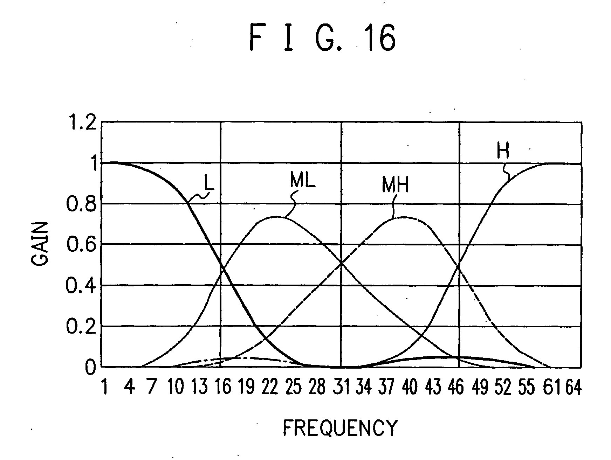

With such cascade connections, an overlap between the two frequency characteristics is extracted as shown in FIGS. 15A to 15D. Thus, the filters 83 to 86 in the subsequent stage output four-channel sound signals having different frequency characteristics so that a pass frequency band is slightly shifted from a low-frequency band to a high-frequency band. FIG. 16 is a diagram showing the frequency-gain characteristics of all the four-channel sound signals. For convenience of explanation, the sound signals outputted from the filters 83 to 86 are referred to as L output, ML output, MH output, and H output in increasing order of a pass frequency band.

Four multipliers 87 to 90 shown in FIG. 14 control the gains of the output signals from the filters 83 to 86 according to given gain control signals (L gain, ML gain, MH gain, H gain). An adder 91 sums all the sound signals having been subjected to gain control by the multipliers 87 to 90 and the adder 91 outputs the sum.

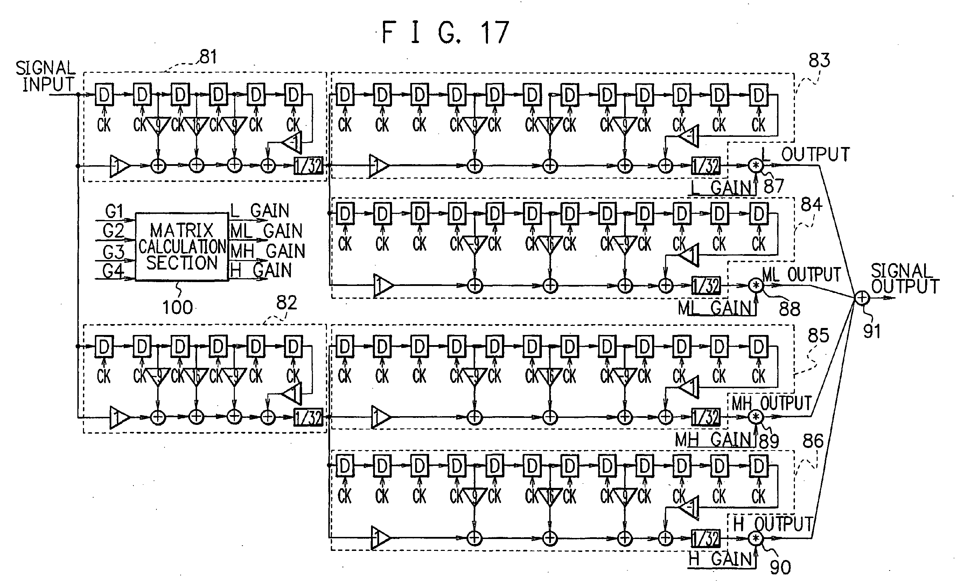

FIG. 17 is a block diagram showing a specific structural example of the sound quality adjusting device which is schematically shown in FIG. 14. In FIG. 17, constituent elements having the same functions as those of FIG. 14 are indicated by the same reference numerals. In the filters 81 and 82 of the previous stage, six cascaded D-type flip-flops sequentially delay an input sound signal by one clock CK. Then, signals extracted from the input/output taps of the D-type flip-flops are multiplied by filter factors of a sequence {-1, 0, 9, 16, 9, 0, -1}/32 or {1, 0, -9, 16, -9, 0, 1}/32 by five factor units, and the multiplication results are all added and outputted.

Further, in the filters 83 to 86 of the subsequent stage, since the frequency axes are half those of the filters 81 and 82 of the previous stage, twelve D-type flip-flops, which are twice the D-type flip-flops of the previous stage, are cascaded to constitute a tapped delay line, and the taps for providing five factor units are spaced twice the previous stage.

That is, in the filters 83 to 86 of the subsequent stage, the cascaded twelve D-type flip-flops sequentially delay an input sound signal by one clock CK. Then, signals extracted from the input/output taps of the D-type flip-flops are multiplied by filter factors of a sequence {-1, 0, 9, 16, 9, 0, -1}/32 or {1, 0, -9, 16, -9, 0, 1}/32 by five factor units, and the multiplication results are all added and outputted.

The four multipliers 87 to 90 control the gains of the output signals (L output, ML output, MH output, and H output) from the filters 83 to 86 according to given gain control signals (L gain, ML gain, MH gain, H gain). The adder 91 sums all the sound signals having been subjected to gain control by the multipliers 87 to 90 and the adder 91 outputs the sum. The gain control signals are obtained by a matrix calculation section 100.

Besides, in the filters 83 to 86 of the subsequent stage, a method of setting the frequency axis at half that of the filters 81 and 82 of the previous stage is not limited to the example of FIG. 17. For example, the filters 83 to 86 in the subsequent stage may be configured as the filters 81 and 82 in the previous stage, and the frequency of the clock to the D-type flip-flops in the subsequent stage may be set at half that of the previous stage. With this configuration, it is possible to reduce the number of uses of the D-type flip-flops and simplify the circuit configuration.

The following will describe a calculation example of the matrix calculation section 100 (method of controlling the frequency characteristics of the sound quality adjusting device).

When the gain control signals (L gain, ML gain, MH gain, and H gain) of each channel are all set at 1, each channel has the frequency-gain characteristics shown in FIG. 16. As is evident from FIG. 16, a gain at a certain frequency is obtained as the total of four-channel gains.

Therefore, in order to control the overall frequency characteristics, it is necessary to calculate a gain component at the center frequency of each channel to obtain the gain control signal of each channel. Hence, at the center frequency of each channel (frequency values of 9, 25, 41, and 57 in FIG. 16), a gain component of each channel is first extracted as follows:

At the center frequency (frequency value =9) of L output, each channel has a gain component of:

$$0.938 \ 0.058 \ 0 \ 0$$

(L, ML, MH, and H from the left). Similarly at the center frequencies of ML output, MH output, and H output, each channel has gain components of:

$$0.045 \ 0.728 \ 0.214 \ 0.013$$

$$0.013 \ 0.214 \ 0.728 \ 0.045$$

$$0 \ 0 \ 0.058 \ 0.938$$

The gain components are expressed as a matrix (matrix A) in FIG. 18.

Meanwhile, the user of the sound quality adjusting device arbitrarily sets desired values G1 to G4 as gains at the center frequencies of the channels. The matrix calculation section 100 performs a matrix operation discussed below by using the matrix A, which indicates the gain components of the center frequencies in FIG. 18, and the desired gain values G1 to G4 at the center frequencies that are set by the user, so that a gain control signal (L gain, ML gain, MH gain, and H gain) of each channel is determined.

That is, as shown in FIG. 19, the values of each column in the matrix A are replaced with desired gain values G1 to G4 to form four matrixes B1 to B4, and the following matrix operation is performed.

$$L \ gain = matrix \ B1/matrix \ A = 0.585$$

$$ML \ gain = matrix \ B2/matrix \ A = 0.893$$

$$MH \ gain = matrix \ B3/matrix \ A = 1.419$$

$$H \ gain = matrix \ B4/matrix \ A = 1.512$$

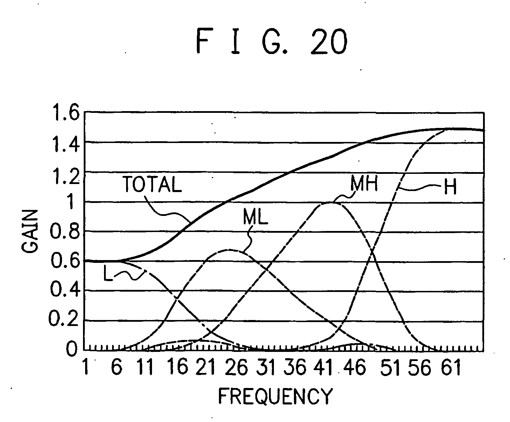

When these gain control signals are used as the multiplier factors of the multipliers 87 to 90, an obtained sound signal has frequency-gain characteristics shown in FIG. 20.

In this way, according to the present embodiment, the gain control signal of each channel can be determined only by performing a simple matrix operation. Additionally, the matrix A from which the matrix operation is originated is peculiar to a four-channel filter bank. Thus, the matrix A can be stored beforehand as numerical data or table information and so forth. Hence, it is possible to control frequency characteristics with quite a simple operation according to predetermined fixed values and desired values set by the user.

The technique for sound quality adjustment in the present embodiment can be realized any one of a hardware structure, DSP, and software. The above explanation described the example of a hardware configuration. For example, when the technique is realized by software, the sound quality adjusting device of the present embodiment is actually constituted of the CPU or MPU, RAM, ROM, and so forth and are realized by operating programs stored in the RAM and ROM.

Therefore, a program for operating a computer to perform the functions of the present embodiment is recorded in a recording medium such as a CD-ROM and the computer is caused to read the program, so that the technique is realized. A recording medium for recording the program includes a flexible disk, a hard disk, a magnetic tape, an optical disk, a magneto-optical disk, a DVD, and a nonvolatile memory card in addition to a CD-ROM. Further, the programs may be downloaded to the computer via a network such as the Internet.

Such a program is included in the present embodiment of the present invention not only when the computer' executes the supplied program so as to realize the functions of the present embodiment but also when the functions of the embodiment are realized in cooperation with an OS (operating system) operating in the computer or another application software and so on and when the processing of the supplied program is entirely or partly performed by a feature expansion board and a feature expansion unit and realizes the functions of the present embodiment.

Further, in the above-described embodiment, the sequence with ratios of {-1, 0, 9, 16, 9, 0, -1} was used as the filter factors of the low-pass filter and the sequence with ratios of {1, 0, -9, 16, -9, 0, 1} was used as the filter factors of the high-pass filter. Other sequences may be used as filter factors as long as the conditions described in the present embodiment are satisfied.

Besides, the above embodiment described an example of a two-channel filter bank in FIG. 1 and an example of a four-channel filter bank in FIG. 14. A pair of the low-pass filter and the high-pass filter is cascaded in n stages, so that a $2^n$ channel filter bank can be configured.

Further, the cascade connection is not limited to FIG. 14. That is, any configuration is included in the present invention as long as at least one of a low-pass filter and a high-pass filter is cascaded in the subsequent stage of at least one of a low-pass filter and a high-pass filter.

Moreover, in the present embodiment, the frequency characteristics of the low-pass filter and the high-pass filter are laterally and vertically symmetrical in a perfect manner as shown in FIG. 5. The frequency characteristics are not particularly limited. That is, any filer factors may be used as long as frequency characteristics are complementary to each other and the total gain of each filter is equal to the reference value at all frequencies. Such filter factors can be obtained by reversing the signs of values other than the median of a sequence of basic filter factors while the absolute values of the sequence are caused to remain the same, and subtracting the median of the sequence from the reference value. In the case of a symmetrical filter, both of the above method and the method of the present embodiment can design the filter with completely the same filter factors.

Additionally, the embodiment just described one example of embodying the present invention and thus the technical scope of the present invention should not be interpreted in a limited manner. That is, the present invention may be embodied in various forms without departing from the spirit or main characteristics of the invention.

As described above, according to the present invention, it is possible to prevent phase distortion even when a desired frequency band is emphasized, obtain good quality sound on audibility by digital signal processing, and readily design a filter circuit used for sound quality adjustment.

[Industrial Applicability]

The present invention is useful for preventing phase distortion even when a desired frequency band is emphasized, obtaining good quality sound on audibility by digital signal processing, and readily designing a filter circuit used for sound quality adjustment.

**Claims**

1. A sound quality adjusting device for causing an input sound signal to pass through a plurality of digital filters, controlling gains of output signals from the plurality of digital filters, summing sound signals having been subjected to gain control, and outputting a sum, the device comprises:

   a first filter for multiplying a signal of each tap of a tapped delay line by several times according to given first filter factors and then performing addition and output, the delay line being made up of a plurality of delay units; and
   a second filter for multiplying a signal of each tap of a tapped delay line by several times according to given second filter factors and then performing addition and output, the delay line being made up of a plurality of delay units;

   wherein
   the first filter factors have a symmetrical sequence in which values are set so that a sum is not zero and a sum of every other terms is equal to a sum of the other every other terms with the same signs; and
   the second filter factors have a symmetrical sequence in which values are set so that a sum is zero and a sum of every other terms is equal to a sum of the other every other terms with opposite signs.

2. The sound quality adjusting device according to claim 1, in the second filter factors, signs of values other than a median of the sequence of the first filter factors are changed while causing absolute values of the sequence to remain the same.

3. The sound quality adjusting device according to claim 1, in the second filter factors, signs of values other than a median of the sequence of the first filter factors are changed while causing absolute values of the sequence to remain the same, and the median of the sequence is subtracted from a reference value.

4. The sound quality adjusting device according to claim 1, the sequence of the first filter factors is composed of ratios of -1, 0, 9, 16, 9, 0, and -1 and the sequence of the second filter factors is composed of ratios of 1, 0, -9, 16, - 9, 0, and 1.

5. The sound quality adjusting device according to claim 1, at least one of the first filter and the second filter is cascaded to a subsequent stage of at least one of the first filter and the second filter.

6. The sound quality adjusting device according to claim 1, the first filter and the second filter are cascaded in parallel to a subsequent stage of the first filter, the first filter and the second filter are cascaded in parallel to a subsequent stage of the second filter, control is performed on a gain of an output signal from each of the cascaded filters in the subsequent stage, and sound signals having been subjected to gain control are summed and outputted.

7. A filter device, comprises:

a first filter for multiplying a signal of each tap of a tapped delay line by several times according to given first filter factors and then performing addition and output, the' delay line being made up of a plurality of delay units; and a second filter for multiplying a signal of each tap of a tapped delay line by several times according to given second filter factors and then performing addition and output, the delay line being made up of a plurality of delay units;

wherein

the first filter factors have a symmetrical sequence in which values are set so that a sum is not zero and a sum of every other terms is equal to a sum of the other every other terms with the same signs; and

the second filter factors have a symmetrical sequence in which values are set so that a sum is zero and a sum of every other terms is equal to a sum of the other every other terms with opposite signs.

8. The filter device according to claim 7, in the second filter factors, signs of values other than a median of the sequence of the first filter factors are changed while causing absolute values of the sequence to remain the same.

9. The filter device according to claim 7, in the second filter factors, signs of values other than a median of the sequence of the first filter factors are changed while causing absolute values of the sequence to remain the same, and the median of the sequence is subtracted from a reference value.

10. The filter device according to claim 7, the sequence of the first filter factors is composed of ratios of -1, 0, 9, 16, 9, 0, and -1 and the sequence of the second filter factors is composed of ratios of 1, 0, -9, 16, -9, 0, and 1.

11. The filter device according to claim 7, at least one of the first filter and the second filter is cascaded to a subsequent stage of at least one of the first filter and the second filter.

12. A sound quality adjusting method, comprising:

a first filtering step of multiplying a signal of each tap of a tapped delay line, which delays an input sound signal, by several times by using first filter factors and then performing addition and output , the first filter factors having a symmetrical sequence in which values are set so that a sum is not zero and a sum of every other terms is equal to a sum of the other every other terms with the same signs;
a second filtering step of multiplying a signal of each tap of a tapped delay line, which delays an input sound signal, by several times by using second filter factors and then performing addition and output, the second filter factors having a symmetrical sequence in which values are set so that a sum is zero and a sum of every other terms is equal to a sum of the other every other terms with opposite signs;
a gain controlling step of controlling a gain of a sound signal having passed through the first filtering step and a gain of a sound signal having passed through the second filtering step; and
a summing step of summing the sound signals having undergone gain control in the gain controlling step and outputting a sum.

13. The sound quality adjusting method according to claim 12, the sequence of the first filter factors is composed of ratios of -1, 0, 9, 16, 9, 0, and -1 and the sequence of the second filter factors is composed of ratios of 1, 0, -9, 16, - 9, 0, and 1.

14. A filter designing method for designing a plurality of digital filters in which frequency characteristics are complementary to each other and a total gain of the filters serves as a reference value at all frequencies, based on first filter factors having a symmetrical sequence in which values are set so that a sum is not zero and a sum of every other terms is equal to a sum of the other every other terms with the same signs, the sequence of the first filter factors is changed, so that second filter factors having a symmetrical sequence are determined in which values are set so that a sum is zero and a sum of every other terms is equal to a sum of the other every other terms with opposite signs, and the first filter factors and the second filter factors are used as the filter factors of the plurality of digital filters.

15. A filter designing method for designing a plurality of digital filters in which frequency characteristics are complementary to each other and a total gain of the filters serves as a reference value at all frequencies,

based on second filter factors having a symmetrical sequence in which values are set so that a sum is zero and a sum of every other terms is equal to a sum of the other every other terms with opposite signs, the sequence of the second filter factors is changed, so that first filter factors having a symmetrical sequence are determined in which values are set so that a sum is not zero and a sum of every other terms is equal to a sum of the other every other terms with the same signs, and the first filter factors and the second filter factors are used as the filter factors of the plurality of digital filters.

**Amended claims under Art. 19.1 PCT**

**1.** A sound quality adjusting device for causing an input sound signal to pass through a plurality of digital filters, controlling gains of output signals from the plurality of digital filters, summing sound signals having been subjected to gain control, and outputting a sum, the device comprises:

a first filter for multiplying a signal of each tap of a tapped delay line by several times according to given first filter factors and then performing addition and output, the delay line being made up of a plurality of delay units; and
a second filter for multiplying a signal of each tap of a tapped delay line by several times according to given second filter factors and then performing addition and output, the delay line being made up of a plurality of delay units;

wherein

the first filter factors have a symmetrical sequence in which values are set so that a sum is not zero and a sum of every other terms is equal to a sum of the other every other terms with the same signs; and

the second filter factors have a symmetrical sequence in which values are set so that a sum is zero and a sum of every other terms is equal to a sum of the other every other terms with opposite signs, the second filter factors are obtained when the signs of values other than a median of the sequence of the first filter factors are changed while causing absolute values of the sequence to remain the same.

**2.** A sound quality adjusting device for causing an input sound signal to pass through a plurality of digital filters, controlling gains of output signals from the plurality of digital filters, summing sound signals having been subjected to gain control, and outputting a sum, the device comprises:

a first filter for multiplying a signal of each tap of a tapped delay line by several times according to given first filter factors and then performing addition and output, the delay line being made up of a plurality of delay units; and
a second filter for multiplying a signal of each tap of a tapped delay line by several times according to given second filter factors and then performing addition and output, the delay line being made up of a plurality of delay units;

wherein

the first filter factors have a symmetrical sequence in which values are set so that a sum is not zero and a sum of every other terms is equal to a sum of the other every other terms with the same signs; and

the second filter factors have a symmetrical sequence in which values are set so that a sum is zero and a sum of every other terms is equal to a sum of the other every other terms with opposite signs, the second filter factors are obtained when the signs of values other than a median of the sequence of the first filter factors are changed while causing absolute values of the sequence to remain the same, and the median of the sequence is subtracted from a reference value.

**3.** A filter device, comprises:

a first filter for multiplying a signal of each tap of a tapped delay line by several times according to given first filter factors and then performing addition and output, the delay line being made up of a plurality of delay units; and
a second filter for multiplying a signal of each tap of a tapped delay line by several times according to given second filter factors and then performing addition and output, the delay line being made up of a plurality of delay units;

wherein

the first filter factors have a symmetrical sequence in which values are set so that a sum is not zero and a sum of every other terms is equal to a sum of the other every other terms with the same signs; and

the second filter factors have a symmetrical sequence in which values are set so that a sum is zero and a sum of every other terms is equal to a sum of the other every other terms with opposite signs, the second filter factors are obtained when the signs of values other than a median of the sequence of the first filter factors are changed while causing absolute values of the sequence to remain the same.

**4.** A filter device, comprises:

a first filter for multiplying a signal of each tap of a tapped delay line by several times according to given first filter factors and then performing addition and output, the delay line being made up of a plurality of delay units; and a second filter for multiplying a signal of each tap of a tapped delay line by several times according to given second filter factors and then performing addition and output, the delay line being made up of a plurality of delay units;

wherein

the first filter factors have a symmetrical sequence in which values are set so that a sum is not zero and a sum of every other terms is equal to a sum of the other every other terms with the same signs; and

the second filter factors have a symmetrical sequence in which values are set so that a sum is zero and a sum of every other terms is equal to a sum of the other every other terms with opposite signs, the second filter factors are obtained when the signs of values other than a median of the sequence of the first filter factors are changed while causing absolute values of the sequence to remain the same, and the median of the sequence is subtracted from a reference value.

# F I G. 1

# F I G. 2

# F I G. 3

# F I G. 4

# F I G. 5

# F I G. 6A

INPUT

31 32 33

34 a 35 b 36 a

37

+ → OUTPUT

BASIC

# F I G. 6B

INPUT

1 2 1

+ 1/4 → OUTPUT

LPF

# F I G. 6C

INPUT

−1 2 −1

+ 1/4 → OUTPUT

HPF

# F I G. 7A

# F I G. 7B

F I G. 8A

F I G. 8B

F I G. 8C

# F I G. 9

# F I G. 10

# F I G. 11

I : a=−1/32
II : a=−2/32
III : a=−3/32
IV : a=−4/32

# F I G. 12A

# F I G. 12B

# F I G. 13A

# F I G. 13B

# F I G. 14

L GAIN

83

LPF

87

ML GAIN

81

84

88

LPF

INPUT
SOUND

HPF

91

MH GAIN

82

85

89

HPF

X

OUTPUT
SOUND

HPF

86

H GAIN

LPF

X

90

# F I G. 15A

81'

83'

L

# F I G. 15B

81'

84'

ML

# F I G. 15C

82'

85'

MH

# F I G. 15D

82'

86'

H

# F I G. 16

F I G. 17

# F I G. 18

|   | L | ML | MH | H |   |
|---|---|---|---|---|---|
|   | 0.938 | 0.058 | 0 | 0 |   |
|   | 0.045 | 0.728 | 0.214 | 0.013 | =A |
|   | 0.013 | 0.214 | 0.728 | 0.045 |   |
|   | 0 | 0 | 0.058 | 0.938 |   |

# F I G. 19

|   | L | ML | MH | H |   |
|---|---|---|---|---|---|
|   | 0.6 | 0.058 | 0 | 0 |   |
|   | 1 | 0.728 | 0.214 | 0.013 | =B1 |
|   | 1.3 | 0.214 | 0.728 | 0.045 |   |
|   | 1.5 | 0 | 0.058 | 0.938 |   |

|   | L | ML | MH | H |   |
|---|---|---|---|---|---|
|   | 0.938 | 0.6 | 0 | 0 |   |
|   | 0.045 | 1 | 0.214 | 0.013 | =B2 |
|   | 0.013 | 1.3 | 0.728 | 0.045 |   |
|   | 0 | 1.5 | 0.058 | 0.938 |   |

|   | L | ML | MH | H |   |
|---|---|---|---|---|---|
|   | 0.938 | 0.058 | 0.6 | 0 |   |
|   | 0.045 | 0.728 | 1 | 0.013 | =B3 |
|   | 0.013 | 0.214 | 1.3 | 0.045 |   |
|   | 0 | 0 | 1.5 | 0.938 |   |

|   | L | ML | MH | H |   |
|---|---|---|---|---|---|
|   | 0.938 | 0.058 | 0 | 0.6 |   |
|   | 0.045 | 0.728 | 0.214 | 1 | =B4 |
|   | 0.013 | 0.214 | 0.728 | 1.3 |   |
|   | 0 | 0 | 0.058 | 1.5 |   |

# F I G. 20

F I G. 21A

F I G. 21B

## INTERNATIONAL SEARCH REPORT

| International application No. |
|---|
| PCT/JP02/09047 |

A. CLASSIFICATION OF SUBJECT MATTER
Int.Cl⁷ H03H17/06, H03H17/02

According to International Patent Classification (IPC) or to both national classification and IPC

B. FIELDS SEARCHED

Minimum documentation searched (classification system followed by classification symbols)
Int.Cl⁷ H03H17/00-17/08, H03G5/00-5/28

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 6-289898 A (Sony Corp.),<br>18 October, 1994 (18.10.94),<br>Fig. 5<br>(Family: none) | 1,4,5,11-13<br>2,3 |
| X<br>Y<br>A | JP 6-326555 A (Sony United Kingdom Ltd.),<br>25 November, 1994 (25.11.94),<br>Par. Nos. [0020], [0022]; Fig. 2<br>(Family: none) | 7,10,14,15<br>1,4-6,11-13<br>2,3,8,9 |
| Y | JP 56-20320 A (Yoshinobu HIRATA),<br>25 February, 1981 (25.02.81),<br>Page 3, lower right column, lines 1 to 17; Fig. 7<br>(Family: none) | 5,11 |

| ☒ Further documents are listed in the continuation of Box C. | ☐ See patent family annex. |
|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 28 November, 2002 (28.11.02) | 17 December, 2002 (17.12.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

# INTERNATIONAL SEARCH REPORT

| International application No. |
| --- |
| PCT/JP02/09047 |

| C (Continuation). DOCUMENTS CONSIDERED TO BE RELEVANT | | |
| --- | --- | --- |
| Category* | Citation of document, with indication, where appropriate, of the relevant passages | Relevant to claim No. |
| Y | JP 63-5607 A (Fujitsu Ten Ltd.),<br>11 January, 1988 (11.01.88),<br>Page 2, upper right column, lines 9 to 14; Fig. 1<br>(Family: none) | 6 |

Form PCT/ISA/210 (continuation of second sheet) (July 1998)